# EUROPÄISCHE PATENTSCHRIFT

(11) **EP 0 934 533 B1**
(45) Veröffentlichungstag und Bekanntmachung des Hinweises auf die Patenterteilung: **09.08.2000**
(21) Anmeldenummer: 97911225.7
(22) Anmeldetag: 15.10.1997
(51) Int. Cl.: G01R 31/02, G01R 31/00

(54) **SCHALTUNGSANORDNUNG ZUR LECKSTROMÜBERWACHUNG**
SWITCHING ARRANGEMENT FOR MONITORING LEAKAGE CURRENT
SYSTEME DE COMMUTATION POUR CONTROLER LE COURANT DE FUITE

(30) Priorität: 24.10.1996 DE 19644181
(43) Veröffentlichungstag der Anmeldung: 11.08.1999
(73) Patentinhaber: Continental Teves AG & Co. oHG, 60488 Frankfurt (DE)
(72) Erfinder: ZYDEK, Michael, D-35428 Langgöns (DE); FEY, Wolfgang, D-65527 Niedernhausen (DE); HEINZ, Micha, D-64293 Darmstadt (DE)
(74) Vertreter: Blum, Klaus-Dieter, Dipl.-Ing.
(86) Internationale Anmeldenummer: EP9705684
(87) Internationale Veröffentlichungsnummer: WO9818014

(56) Entgegenhaltungen:
- EP-A- 0 418 665
- DE-A- 4 242 177
- DE-A- 19 526 435
- US-A- 5 099 198

## Beschreibung

Die Erfindung bezieht sich auf eine Schaltungsanordnung zur Leckstromüberwachung eines Schaltkreises, der eine Vielzahl von parallel an eine Versorgungsleitung angeschlossenen, über Einzelschalter an den zweiten Pol einer Versorgungsspannungsquelle bzw. an Masse anschaltbare Spulen oder andere induktive Lasten enthält und bei dem die Versorgungsleitung über einen Hauptschalter an die Versorgungsspannungsquelle bzw. an den ersten Pol der Versorgungsspannungsquelle sowie zur Leckstromüberprüfung an eine Hilfsquelle oder Prüfsignalquelle anschaltbar ist, die eine zur Leckstromerkennung auswertbare Potentialänderung auf der Versorgungsleitung hervorruft. Es ist dabei insbesondere an einen Schaltkreis zur Ansteuerung der Ventilspulen einer geregelten Bremsanlage gedacht.

Aus der DE 42 42 177 A1 (P 7433) ist eine Schaltungsanordnung dieser Art bekannt, die zur Überwachung von Ventilspulen einer geregelten Bremsanlage und der zugehörigen Ansteuerstufen dient. Die Ventilspulen sind einerseits über einen gemeinsamen Hauptschalter oder ein (Halbleiter-)Relais an den positiven Pol der Fahrzeugbatterie und andererseits über jeweils eine Endstufe bzw. einen Einzelschalter an Masse geschaltet. Zur Leckstromerkennung wird eine Hilfsspannungsquelle über einen hochohmigen Widerstand an die von dem Hauptschalter zu den Ventilspulen führende gemeinsame Versorgungsleitung angeschlossen. Es wird das Potential auf dieser Versorgungsleitung bei geöffnetem Hauptschalter gemessen und ausgewertet. Bei einem Nebenschluß oder Leckstrom von der Versorgungsleitung zur Versorgungsquelle oder zur Masse hin ändert sich das Potential auf der Versorgungsleitung. Über einen Spannungsteiler und ein Potentialmonitor werden Potentialverschiebungen, die durch Leckströme bedingt sind, erkannt und signalisiert.

Es wurde auch schon bei einer ansonsten ähnlichen Schaltung vorgeschlagen, die zu Prüfzwecken dienende Hilfsspannungsquelle über eine Stromquelle, die aus zwei antiparallel geschalteten Einzelstromquellen bestehen kann, anzuschließen. Solange der Fehlerstrom innerhalb vorgegebener Grenzwerte liegt, bleibt das Potential auf der gemeinsamen Versorgungsleitung annähernd konstant, während bereits eine geringe Überschreitung dieser Grenzwerte zu einer deutlichen und daher leicht auswertbaren Potentialänderung auf der Versor-gungsleitung während der Prüfphase führt (nicht vorveröffentlichte DE 195 26 435.5).

In der US-Patentschrift US-A-5 099 198 ist eine Schaltung zur Überwachung der Endstufen einer Vielzahl von Spulen beschrieben, mit der sowohl ein Ausfall der Stufen als auch das Auftreten von Leckströmen oder Kurzschlüssen erkannt werden können. Zur Fehlererkennung werden die Endstufen mit Testsignalen angesteuert. Die dadurch hervorgerufenen Reaktionen werden durch logische Verknüpfung der Ausgangssignale festgestellt und zur Fehlererkennung ausgewertet.

Aus der EP-A-0418 665 ist auch schon eine Schaltung zur Ansteuerung und Überwachung einer Vielzahl von Spulen und der zugehörigen Endstufen, z.B. der Ventilspulen von elektrisch gesteuerten Hydraulikventilen eines Antiblockiersystems, mit Hilfe eines gemeinsamen Computers bekannt. Es wird eine Fehlerüberwachung und Fehlerbestimmung durchgeführt. Jeder Spule ist eine Logikschaltung mit mehreren, auf verschiedene Funktionsfehler der Spulenkreise (Kurzschluß, Leitungsunterbrechung, Dauersignal) ansprechenden Detektorschaltungen zugeordnet. Zur Überwachung der einzelnen Spulen werden die zugehörigen Logikschaltungen selektiv von dem gemeisamen Steuer- und Prüfcomputer angesteuert.

Der vorliegenden Erfindung liegt nun die Aufgabe zugrunde, eine Schaltungsanordnung der eingangs genannten Art zu entwickeln, mit der mit besonders hoher Zuverlässigkeit Leckströme bzw. Nebenschlüsse unterschiedlicher Art ermittelt werden können. Auf einfachen Aufbau und einfache Auswertbarkeit der Prüfergebnisse wird ebenfalls Wert gelegt.

Es hat sich gezeigt, daß diese Aufgabe durch die im Anspruch 1 beschriebene Schaltungsanordnung gelöst wird, deren Besonderheit darin besteht, daß als Hilfs- oder Prüfsignalquelle eine Stromquelle vorgesehen ist, die vor jedem Schließen des Hauptschalters bei noch offenen Einzelschaltern an die Versorgungsspannungsquelle angeschaltet und dadurch aktiviert wird, worauf dann das sich einstellende Spannungspotential auf der Versorgungsleitung ermittelt und zur Leckstromerkennung ausgewertet wird.

Durch die erfindungsgemäße Schaltungsanordnung wird in der Prüfphase, nämlich nach dem Aktivieren der Prüfstromquelle das Potential auf der Versorgungsleitung bis nahezu auf den vollen Wert der Versorgungsspannung bzw. Batteriespannung angehoben. Im Gegensatz zu bekannten Schaltungen mit niedriger Hilfsspannung und/oder hochohmigen Widerständen im Prüfweg werden durch die Potentialanhebung auf das Batterie-Potentialniveau auch Nebenschlüsse erkannt, die nur bei relativ hohem Spannungsniveau auftreten bzw. ausgelöst werden. Durch Störstellen und Defekte in der Kristallgitterstruktur von Halbleitern kann es zu Nebenschlüssen kommen, die erst ab einem gewissen Spannungspotential wirksam werden. Man kann dieses Verhalten mit dem Zenereffekt vergleichen, bei dem erst oberhalb eines bestimmten Spannungswertes, nämlich der Zenerspannung, ein Stromfluß auftritt.

Nach einem vorteilhaften Ausführungsbeispiel der Erfindung wird in der Prüfphase, d.h. nach Aktivieren der Prüfstromquelle, mit Hilfe eines Komparators die Differenz zwischen dem Potential auf der Versorgungsleitung und dem Potential der Versorgungsspannungsquelle ermittelt. Übersteigt die Differenz einen bestimmten, relativ geringen Spannungsschwellwert, ist dies ein Hinweis auf einen Nebenschluß bzw. auf einen Leckstrom. Diese Art der Fehlerermittlung ist besonders einfach zu realisieren und funktioniert zuverlässig.

Es ist zweckmäßig, die Potentialdifferenz, die sich als Folge der Aktivierung der Prüfstromquelle einstellt, erst nach einer bestimmten Wartezeit auszuwerten, um auch einen Nebenstrom zu erfassen, der über eine induktive Last, insbesondere über eine der Ventilspulen fließt. Wegen der Induktivität stellt sich nämlich unter bestimmten Bedingungen die Potentialänderung auf der Versorgungsleitung als Folge des Einschaltens der Prüfstromquelle erst nach einer bestimmten Verzögerungszeit ein.

In den beigefügten Unteransprüchen sind noch weitere vorteilhafte Ausführungsbeispiele der Erfindung beschrieben.

Weitere Einzelheiten der Erfindung gehen aus der folgenden Beschreibung eines Ausführungsbeispiels anhand der beigefügten Abbildungen hervor.

Es zeigen:
- Fig. 1: im Blockschaltbild, schematisch vereinfacht, die wesentlichen Komponenten einer Schaltungsanordnung nach der Erfindung und
- Fig. 2: im Diagramm den Signalverlauf an verschiedenen Stellen der Schaltung nach Fig. 1 während eines Testoder Prüfablaufs.

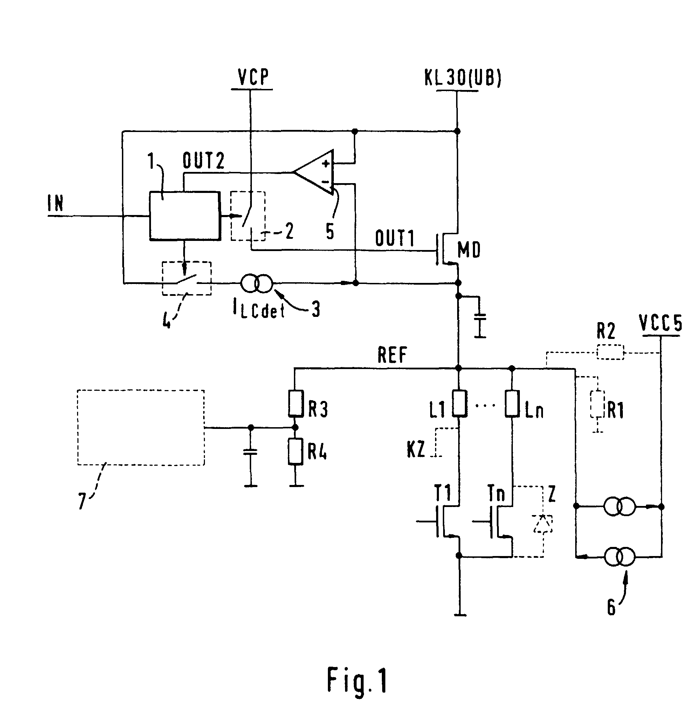

In Fig. 1 ist ein Ventilspulschaltkreis wiedergegeben, der im wesentlichen aus mehreren bzw. einer Vielzahl von parallel geschalteten Ventilspulen L1 bis Ln, die über Einzelschalter oder Treiberstufen T1 bis Tn ein- und ausgeschaltet werden, und aus einem Hauptschalter oder Main Driver MD besteht. Die Stromversorgung erfolgt, wie bei einem Kraftfahrzeug üblich, über die Fahrzeugklemme KL30, die im vorliegenden Beispiel zum Pluspol der Fahrzeugbatterie mit der Spannung UB führt und über den symbolisch dargestellten Masse-Anschluß. Der Main Driver MD wird folglich auch als High-Side-Driver, die Einzelschalter oder Transistoren T1 bis Tn werden als Low-Side-Driver bezeichnet.

Zu den Basiskomponenten dieses Ventilschaltkreises zählt außerdem die Ansteuerung des Hauptschalters MD durch eine Logikschaltung oder Logik 1. Beim Anlegen eines Eingangssignals IN wird über die Logikschaltung 1 und einen Schalter 2 ein Gatesignal oder Ansteuersignal OUT1 zum Einschalten des Hauptschalters bzw. Schließen des MD erzeugt. VCP ist die für den Main Driver MD erforderliche Ansteuerspannung, die bei einer solchen Schaltung über der Batteriespannung UB liegen muß.

Bekanntlich wird bei einem Schaltkreis der dargestellten Art, der zur Ansteuerung der Ventilspulen einer geregelten Bremsanlage dient, beim Einsetzen der Regelung bis zur Beendigung eines geregelten Bremsvorganges der Hauptschalter MD geschlossen. Über die Einzelschalter oder Low-Side-Driver T1 bis Tn wird dann durch Anlegen variabler Pulsfolgen die Bremsdruckregelung bewirkt. Die Pulsdauer, Pulsfolgen, Pulspausenverhältnisse usw. werden dabei von der (nicht dargestellten) Regellogik der Bremsanlage errechnet und vorgegeben.

Erfindungsgemäß wird vor jedem Einschalten des Main Drivers MD bzw. Schließen des Hauptschalters eine Leckstromüberprüfung durchgeführt. Wird das Vorhandensein von Leckströmen, die zulässige Mindestwerte überschreiten, festgestellt, verhindert die Leckstromüberwachung das Einschalten und das Schließen des Hauptschalters MD.

Zur Leckstromüberwachung ist nach Fig. 1 eine Stromquelle 3 vorgesehen, die zur Durchführung der Prüfung über einen Schalter 4, den die Logik 1 betätigt, durch Anschluß an die Versorgungsspannung oder Batteriespannung aktiviert wird. Die Versorgungsspannung liegt an dem Klemme KL30 an. Während dieses Prüfvorgangs sind der Hauptschalter MD und die Einzelschalter T1 bis Tn offen. Die Stromquelle 3 wird z.B. für einen eingeprägten Strom von 30 mA ausgelegt. Wenn kein Nebenschluß existiert bzw. der Nebenschluß oder Leckstrom einen vorgegebenen Grenzwert nicht überschreitet, wird durch die Stromquelle das Potential auf der Versorgungsleitung REF bis (nahezu) auf das Potential der Versorgungsspannung bzw. Batteriespannung UB (Klemme 30) angehoben. Mit Hilfe eines Komparators 5 braucht nun nur noch die Differenz zwischen dem Potential auf der Versorgungsleitung REF und dem Potential an der Klemme KL30 ermittelt zu werden; liegt die Differenz unter einem vorgegebenen Grenzwert im Bereich von z.B. 1 bis 2 Volt, deutet dies auf eine intakte Schaltung hin.

Der Komparator 5 signalisiert daher der Logik 1 das Überprüfungsergebnis (OUT2). Wird kein Nebenschluß oder Leckstrom festgestellt, wird der Schalter 4 wieder geöffnet und dadurch die Stromquelle 3 inaktiviert. Über den Schalter 2 wird der Main Driver oder High-Side-Driver MD angesteuert.

Punktiert sind in Fig. 1 einige in der Praxis auftretende Nebenschlußvarianten angedeutet. Die zur Masse führende Linie KZ nahe L1 stellt einen Kurzschluß dar. Nebenschlüsse zur Masse und zu einer Hilfsspannungsquelle VCC5 - solche Hilfsspannungsquellen sind bei Schaltungen der hier in Rede stehenden Art üblich - rufen Leckströme unterschiedlicher Höhe hervor. Eine angedeutete Zenerdiode Z, die dem Einzelschalter bzw. dem Low-Side-Driver Tn parallel liegt, symbolisiert einen Halbleiterdefekt, der nur oberhalb einer bestimmten Spannung (Zenerspannung) in Erscheinung tritt; beim Prüfen der Schaltung mit einer Prüfquelle niedrigen Potentials würde der Nebenschluß über die Zenerdiode Z folglich nicht erkannt werden.

Im Fehlerfall, das heißt bei einem Leckstrom nach Masse über R1 oder KZ oder zur Hilfsquelle VCC5 über R2, wird der durch die Prüfstromquelle 3 eingeprägte Strom abfließen und es somit verhindern, daß das Potential auf der Versorgungsleitung REF über einen bestimmten Wert hinaus angehoben wird. Am Komparator 5 wird die Differenz der Eingangsspannungen zu groß, es wird der vorgegebene Schwellwert (von z.B 1,2 V) überschritten und dadurch über die Logik 1 das Schließen des Schalters 2 und damit des Hauptschalters MD verhindert.

Die dargestellte Antiparallelschaltung 6 zweier weiterer Stromquellen und der links einer strichpunktierten Linie dargestellte Spannungsteiler R3, R4 mit einem zugehörigen Spannungsmonitor 7 gehören nicht zu den wesentlichen Bestandteilen der erfindungsgemäßen Überwachungsschaltung. Diese Komponenten wurden lediglich in Fig. 1 eingefügt, um darzustellen, daß aus anderen Gründen vorhandene Schaltungsteile, Überwachungsschaltkreise usw. angeschlossen sein können, ohne die Funktion der erfindungsgemäßen Leckstromüberwachung zu behindern. Durcn diese zusätzlichen Komponenten wird lediglich der zulässige Nebenfluß oder Leckstrom, der bei der Dimensionierung der Prüfstromquelle 3 und den Schwellwerten des Komparators 5 vorgegeben werden muß, beeinflußt.

Falls ein Leckstrom unterhalb der Ventilspulen L1 bis Ln, d.h. zwischen den Ventilspulen und dem Masseanschluß, auftritt, beispielsweise durch den Kurzschluß KZ oder Nebenschluß oder über die Zenerdiode Z, wird bei dem durch das Aktivieren der Prüfstromquelle 3 ausgelösten Prüfvorgang ein Strom in eine induktive Last eingeprägt. Nach dem Aktivieren der Stromquelle 3 wird daher das Potential auf der Versor-gungsleitung REF ansteigen, bis die Induktivität der betroffenen Ventilspule einen Stromfluß in der Größenordnung des eingeprägten Stromes zuläßt.

Die Potentialanhebung auf der Versorgungsleitung REF erfolgt nicht sofort, sondern erst nach einer bestimmten Zeitspanne, die von der Induktivität der betroffenen Ventilspule L1 bis Ln abhängig ist. Bis zum Auswerten der Potentialänderung nach dem Aktivieren der Prüfstromquelle 3 wird daher eine bestimmte Verzögerungs- oder Wartezeit t_{Test} vorgegeben. Erst nach Ablauf dieser Wartezeit oder Verzögerungszeit wird festgestellt, ob die Potentialanhebung ausreichend bzw. die Potentialdifferenz an den Eingängen des Komparators 5 unter dem vorgegebenen Schwellwert liegt. Die Zeitdauer oder Wartezeit t_{Test}, die bis zu einem sicheren Erkennen eines Leckstroms oder Nebenschlusses verstreichen muß, ist von der Induktivität der Spulen, den Serienwiderständen der Spulen und der Stromquelle sowie ggf. von der Schwellspannung oder der Zenerspannung abhängig.

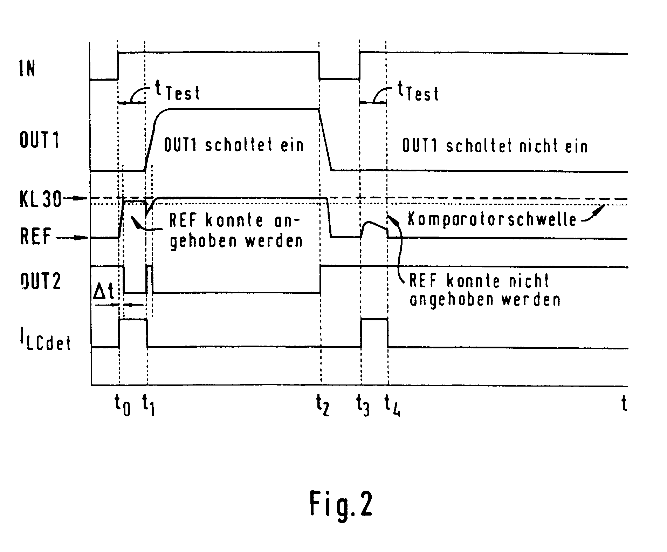

Fig. 2 veranschaulicht die Vorgänge und Potentialänderungen beim Aktivieren und nach dem Aktivieren eines Prüfvorganges. Für alle Kurven gilt der gleiche Zeitmaßstab und Zeitablauf t. Zum Zeitpunkt t₀ erscheint ein Signal IN am Eingang der Logik 1. Wegen einer geringen kapazitiven Last an der Versorgungsleitung REF folgt die Anhebung des Potentials dieser Leitung nach sehr kurzer Verzögerungszeit Δt. Die Komparatorschwelle wurde zum Zeitpunkt t₀+Δt überschritten, und das Ausgangssignal OUT2 des Komparators 5 wechselt. Das Potential der Versorgungsleitung REF konnte also über die erforderliche Schwelle angehoben werden. Nach Ablauf der Testzeit t_{Test} wird zum Zeitpunkt t₁ das Signal OUT2 ausgewertet. Die Leckstromüberprüfung wurde erfolgreich bestanden; es ist kein oder nur ein sehr geringer, zulässiger Leckstrom im gestesteten Schaltungsteil aufgetreten. Zum Zeitpunkt t₁, nach Ablauf der Prüfzeit t_{Test}, wird daher der Schalter 4 geöffnet und durch das Signal OUT1 der Hauptschalter bzw. Main Driver MD geschlossen, weil das Potential auf der Versorgungsleitung REF nahezu den Wert des Potentials an der Klemme KL30 angenommen hatte; die Potentialdifferenz an den Eingängen des Komparators 5 lag unter einem vorgegebenen Schwellwert.

Nach dem Ausschalten oder Öffnen des Hauptschalters MD zum Zeitpunkt t₂ wird zum Zeitpunkt t₃ erneut ein Schließen des Hauptschalters MD erforderlich; dies ist der Kurve IN (IN ist das Eingangssignal der Logik 1) zu entnehmen. Zum Zeitpunkt t₃ wird die Prüfstromquelle 3 aktiviert. Im Gegensatz zum zuvor geschilderten Testablauf (t₀, t₁) wird jedoch in der Zeitspanne t_{Test} das Bezugspotential REF nur geringfügig angehoben. Folglich registriert der Komparator 5 eine zu große, über dem vorgegebenen Schwellwert liegende Potentialdifferenz zwischen dem Potential an der Klemme KL30 und der Versorgungsleitung REF. Zum Zeitpunkt t₄ liegt folglich eine Leckstromerkennung vor, weshalb die Logik 1 (Fig. 1) ein Schließen des Hauptschalters MD verhindert.

Die erfindungsgemäße Schaltungsanordnung ermöglicht also das Erkennen von Leckströmen unterschiedlicher Ursache, die an irgendeiner Stelle im Schaltkreis unterhalb des Hauptschalters MD hervorgerufen werden, solange der Leckstrom oder Nebenstrom größer ist als ein durch die Vorgabe des eingeprägten Stromes der Prüfstromquelle festgelegter Mindeststrom und unterhalb einer Spannung einsetzt, die durch die Schwellspannung des zur Fehlererkennung verwendeten Komparators 5 vorgegeben ist. Insbesondere werden auch "Lecks" der Low-Side-Ventiltreiber T1 bis Tn erkannt, die durch "Pinholes" hervorgerufen werden und sich als Zenereffekte mit Spannungen größer 5 Volt bemerkbar machen.

## Patentansprüche

1. Schaltungsanordnung zur Leckstromüberwachung eines Schaltkreises, der eine Vielzahl von parallel an eine Versorgungsleitung (REF) angeschlossenen, über Einzelschalter (T1...Tn) an den zweiten Pol einer Versorgungsspannungsquelle (UB;KL30) bzw. an Masse anschaltbaren Spulen (L1...Ln) oder anderen induktiven Lasten enthält und bei dem die Versorgungsleitung über einen Hauptschalter (MD) an den ersten Pol der Versorgungsspannungsquelle (UB;KL30) und zur Leckstromüberwachung an eine Hilfs- oder Prüfsignalquelle (3) anschaltbar ist, die eine zur Leckstromerkennung auswertbare Potentialänderung auf der Versorgungsleitung (REF) hervorruft, dadurch **gekennzeichnet,** daß als Hilfs- oder Prüfsignalquelle eine Prüfstromquelle (3) vorgesehen ist, die vor jedem Schließen des Hauptschalters (MD) bei noch offenen Einzelschaltern (T1, Tn) an die Versorgungsspannungsquelle (UB;KL30) angeschaltet und dadurch aktiviert wird , worauf das sich auf der Versor-gungsleitung (REF) einstellende Spannungspotential ermittelt und zur Leckstromerkennung ausgewertet wird.

2. Schaltungsanordnung nach Anspruch 1, dadurch **gekennzeichnet,** daß zur Leckstromerkennung mit Hilfe eines Komparators(5) die Differenz zwischen dem Potential auf der Versorgungsleitung (REF) und der Versorgungsspannungsquelle (UB;KL30) nach dem Aktivieren der Prüfstromquelle (3) ermittelt wird.

3. Schaltungsanordnung nach Anspruch 2, dadurch **gekennzeichnet,** daß durch den Komparator (5) das Einhalten eines vorgegebenen Maximalwertes der Potentialdifferenz überprüft wird.

4. Schaltungsanordnung nach Anspruch 3, dadurch **gekennzeichnet,** daß die Potentialdifferenz erst nach dem Ablauf einer vorgegebenen Verzögerungs- oder Wartezeit (t_{Test}), die mit dem Aktivieren der Prüfstromquelle (3) beginnt, ausgewertet wird.

5. Schaltungsanordnung nach einem oder mehreren der Ansprüche 1 bis 4, dadurch **gekennzeichnet,** daß diese das Schließen des Hauptschalters (MD) verhindert, wenn nach dem Aktivieren der Prüfstromquelle (3) und/oder nach Ablauf der Verzögerungs- oder Wartezeit (t_{Test}) die Potentialdifferenz den vorgegebenen Maximalwert überschreitet.

## Claims

1. Circuit arrangement for monitoring leakage currents of a circuit which includes a plurality of coils (L1...Ln) or other inductive loads connected in parallel to a supply line (REF) and adapted to be connected to the second pole of a supply voltage source (UB;KL30) or to ground by way of individual switches (T1...Tn), and wherein the supply line is adapted to be connected by way of a main switch (MD) to the first pole of the supply voltage source (UB;KL30) and, for leakage current monitoring, to an auxiliary source or test signal source (3) which causes a potential variation on the supply line (REF) that can be evaluated for leakage current detection,
**characterized** in that a testing current source (3) is provided as an auxiliary or test signal source which is connected to the supply voltage source (UB; KL30), and is thereby activated, prior to each closing of the main switch (MD), with the individual switches (T1, Tn) still open, whereupon the voltage potential occurring on the supply line (REF) is determined and evaluated for leakage current detection.

2. Circuit arrangement as claimed in claim 1,
**characterized** in that for leakage current detection, the difference between the potential on the supply line (REF) and the supply voltage source (UB;KL30) is determined after the activation of the testing current source (3) by way of a comparator (5).

3. Circuit arrangement as claimed in claim 2,
**characterized** in that it is checked by the comparator (5) that a predetermined maximum value of the potential difference is maintained.

4. Circuit arrangement as claimed in claim 3,
**characterized** in that the potential difference is evaluated only after a defined delay time or waiting time (t_{Test}) which commences with the activation of the testing current source (3).

5. Circuit arrangement as claimed in any one or more of the claims 1 to 4,
**characterized** in that the circuit arrangement prevents closing of the main switch (MD) if the potential difference exceeds the predetermined maximum value after the activation of the testing current source (3) and/or after the expiry of the delay time or waiting time (t_{Test}).

## Revendications

1. Montage pour le contrôle d'un courant de fuite d'un circuit, qui contient une multiplicité de bobines (L1...Ln) ou d'autres charges inductives, qui sont connectées à une ligne d'alimentation (REF) et peuvent être connectées, par l'intermédiaire d'interrupteurs individuels (T1...Tn) au second pôle d'une source de tension
d'alimentation (UB; KL30) ou à la masse, et dans lequel la ligne d'alimentation peut être connectée par l'intermédiaire d'un interrupteur principal (MD) au premier pôle de la source de la tension d'alimentation (UB; KL30) et pour le contrôle d'un courant de fuite au niveau d'une source de signal auxiliaire ou de contrôle (3), qui provoque une modification de potentiel, pouvant être exploitée pour identifier le courant de fuite, dans la ligne d'alimentation (REF), caractérisé en ce qu'il est prévu comme source de signal auxiliaire ou de contrôle une source de courant de contrôle (3) qui, avant chaque fermeture de l'interrupteur principal (MD) est connectée, lorsque des interrupteurs individuels (T1, Tn) sont encore ouverts, à la source de tension d'alimentation (UB; KL30) et est de ce fait activée, à la suite de quoi le potentiel de tension, qui s'établit dans la ligne d'alimentation (REF), est déterminé et est exploité pour l'identification du courant de fuite.

2. Montage selon la revendication 1, caractérisé en ce que la différence entre le potentiel présent dans la ligne d'alimentation (REF) et la source de tension d'alimentation (UB; KL30) est déterminée après activation de la source de courant de contrôle (3), pour l'identification du courant de fuite, à l'aide d'un comparateur (5).

3. Montage selon la revendication 2, caractérisé en ce que le maintien de la différence de potentiel en deça d'une valeur maximale prédéterminée est contrôlé par le comparateur (5).

4. Montage selon la revendication 3, caractérisé en ce que la différence de potentiel est exploitée uniquement après l'écoulement d'un intervalle de temps prédéterminée de retard ou d'attente (tₜₑₛₜ), qui commence avec l'activation de la source de courant de contrôle (3).

5. Montage selon l'une ou plusieurs des revendications 1 à 4, caractérisé en ce que ce montage empêche la fermeture de l'interrupteur principal (MD) lorsqu'après l'activation de la source de courant de contrôle (3) et/ou après l'écoulement du temps de retard ou d'attente (tₜₑₛₜ), la différence de potentiel dépasse la valeur maximale prédéterminée.
